# EUROPEAN PATENT APPLICATION

(11) **EP 3 370 487 A1**
(43) Date of publication of application: **05.09.2018**
(21) Application number: 17158844.5
(22) Date of filing: 02.03.2017
(51) Int. Cl.: H05K 1/11, H05K 1/02, H05K 3/46

(54) **PACKAGED RF CIRCUITS AND RADIO UNIT**

(71) Applicant: NXP B.V., 5656 AG Eindhoven (NL)
(72) Inventor: Tong, Ziqiang, Redhill, Surrey RH1 1QZ (GB); Reuter, Ralf, Redhill, Surrey RH1 1QZ (GB)
(74) Representative: Terblanche, Candice Jane

(57) **Abstract**

A packaged radio frequency, RF, circuit (500) is described that comprises: a printed circuit board, PCB, substrate comprising at least one electrically conductive transmission line on a top portion of the PCB substrate, wherein the PCB substrate comprises a plurality of vias (520) passing there through coupling the top portion of the PCB substrate to a ground plane; and an integrated circuit package located atop the PCB substrate in a vertical plane and electrically coupled to the PCB substrate via a plurality of ball grid arrays, BGAs (530), wherein a first BGA is configured to carry at least one RF signal (510) from the package to the PCB substrate. In the vertical plane, a first portion of the plurality of vias (520) are offset from an adjacent first portion of the plurality of BGAs (530) by a first distance, and a second portion of the plurality of vias (520) located around a substantial portion of the first BGA are offset from a respective adjacent second portion of the plurality of BGAs (530) by a second distance that is less than the first distance.

## Description

### Field of the invention

The field of the invention relates to packaged radio frequency (RF) circuits, including RF packages and PCB substrate designs for millimetre wave (mmW) radar units. The invention is applicable to, but not limited to, a 77-79GHz mmW radio frequency (RF) front ends or RF input-output circuits to provide wider bandwidth and reduced insertion loss for signals passing from RF packages to a PCB substrate.

### Background of the invention

A majority of the current millimetre wave (mmW) radar unit front-end (i.e. transceiver (TRx) integrated circuit packages are using ball grid array (BGA) packages. A BGA is a type of surface-mount packaging (a chip carrier) used for integrated circuits. BGA packages are used to permanently mount devices, such as microprocessors or radio frequency (RF) components. A BGA can provide more interconnection pins than can be typically put on a dual in-line or flat package.

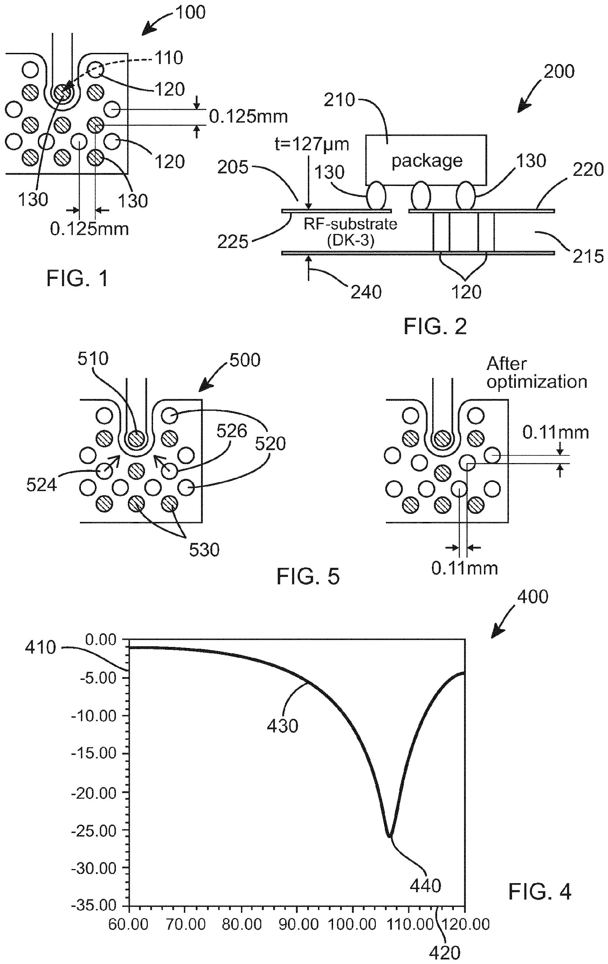

Referring now to FIG. 1, a top view 100 of a typical known package and printed circuit board (PCB) design for a millimetre wave (mmW) radio frequency (RF) port of an RF device, such as a radar unit, is illustrated. The typical known package and PCB design includes a 9-pin BGA and via configuration for 77-79GHz radar applications. The typical known package and PCB design also includes an RF signal BGA 110 that transfers an input RF signal to a PCB that includes a substrate. The top view 100 shows a number of vias 120 that pass through the RF substrate and a number of BGA connections 130 that connect the package to the PCB. One or more of the BGAs may be used to couple a ground plane of the package to a ground plane on the PCB.

Referring now to FIG. 2, a cross-sectional view 200 of the typical known package 210 and PCB 205 for a millimetre wave (mmW) RF device of FIG. 1 is illustrated. The cross-sectional view 200 shows a number of vias 120 passing through the RF substrate 215 of the PCB 205 and a number of BGA connections 130 that connect the package 210 to current carrying transmission lines 220, 225 of the PCB 205. As illustrated, the BGAs 110 connect the package to different transmission lines 220, 225 on the PCB 205. The RF substrate 215 thickness is typically 0.127mm and the BGA-Vias grid pitch is 0.5mm.

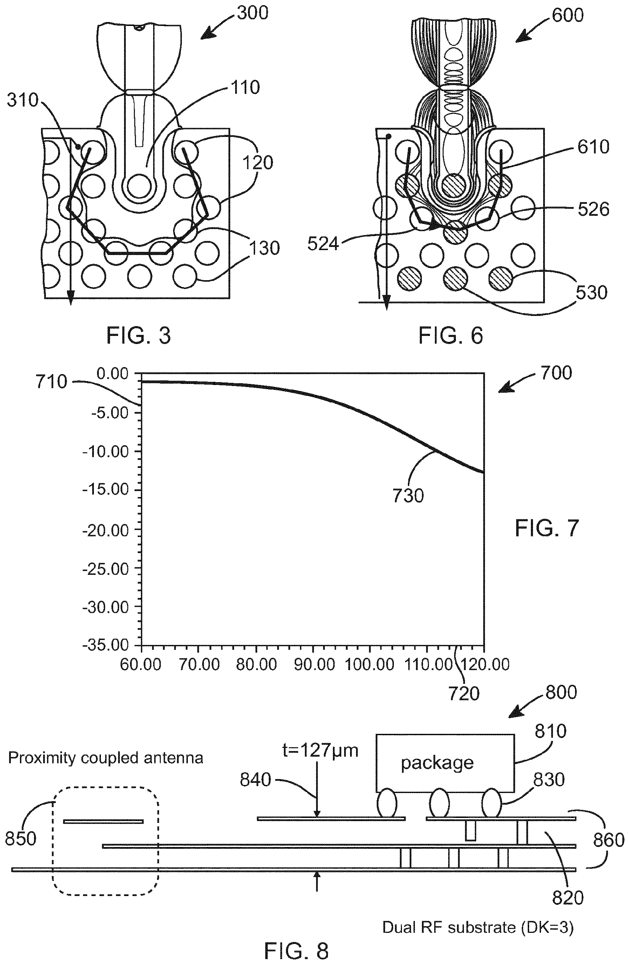

Referring now to FIG. 3, a top view 300 of the known package and PCB design of the RF device of FIG. 1 highlighting a known electro-magnetic field, is illustrated. Again, the top view 300 shows a number of vias 120 passing through the RF substrate and a number of BGA connections 130 that connect the package to transmission lines on the PCB. As illustrated, the location of the vias 120 and BGA connections 130, in the known package and PCB design, create an electro-magnetic field 310 around the RF signal BGA 110.

The inventors of the present invention have identified that this electro-magnetic field 310, in a 77-79GHz radar unit application, effectively forms a boundary of a resonant cavity (akin to an electro-magnetic cage effect) around the RF signal BGA 110 110.

Referring now to FIG. 4, a frequency response simulation 400 of the typical known package and PCB design of FIG. 1 and FIG. 2 and FIG. 3 is illustrated. The frequency response simulation 400 shows a frequency response 430 of frequency 420 versus insertion loss 410 for the typical known package and PCB design. The frequency response simulation 400 shows that the resonant cavity exhibits a band stop behaviour 440 around 100GHz.

Such a frequency response of a known package and PCB design for a mmW RF port is undesirable, not least due to the insertion loss identified at the 77-79GHz operating frequency of the RF device, e.g. radar unit. Thus, a new packaged RF circuit, e.g. for an RF front-end design, is desired.

### Summary of the invention

The present invention provides a packaged RF circuit, a RF unit, a PCB substrate, and an integrated circuit package, as described in the accompanying claims. Specific embodiments of the invention are set forth in the dependent claims. These and other aspects of the invention will be apparent from and elucidated with reference to the embodiments described hereinafter.

### Brief description of the drawings

Further details, aspects and embodiments of the invention will be described, by way of example only, with reference to the drawings. In the drawings, like reference numbers are used to identify like or functionally similar elements. Elements in the figures are illustrated for simplicity and clarity and have not necessarily been drawn to scale.
FIG. 1 illustrates a top view of a typical known package and printed circuit board (PCB) design for a millimetre wave (mmW) radio frequency (RF) port.
FIG. 2 illustrates a cross-sectional view of the typical known package and PCB design for a mmW RF port of FIG. 1.
FIG. 3 illustrates a top view of the typical known package and PCB design for a mmW RF port highlighting a known electro-magnetic field.
FIG. 4 illustrates a frequency response simulation of the typical known package and PCB design for a mmW RF port of FIG. 1 and FIG. 2 and FIG. 3.
FIG. 5 illustrates an example of a packaged RF circuit and PCB substrate with a re-assignment of a selected number of BGAs as Vias, together with a re-location in a PCB substrate, according to example embodiments of the invention.
FIG. 6 illustrates an example packaged RF circuit and PCB substrate showing an electro-magnetic field of the package and PCB of FIG. 5, according to example embodiments of the invention.
FIG. 7 illustrates an example frequency response simulation showing an improvement in insertion loss and operating frequency bandwidth using the example package and PCB substrate of FIG. 5 and FIG, 6, according to example embodiments of the invention.
FIG. 8 illustrates an example of a packaged RF circuit and multi-layer PCB substrate within a standard thickness concept, adapted according to an example embodiment of the invention.

### Detailed description

Examples of the invention are described with reference to shifting a resonance frequency of a radar unit that employs a mmW Radar radio frequency (RF) front-end system, for instance operating in the Automotive Radar frequency band of 77GHz/79GHz. However, it is envisaged, that in other examples the circuits and concepts herein described may be equally applied to any RF device and any very-high operating frequency, particularly any radar units with RF front-end systems, configured to operate at other mmW radar frequencies, for example where the RF device may suffer from or be affected by a band stop resonance frequency response. Examples of the invention describe a number of configurations to shift a resonance frequency of a radar unit to either higher frequencies or lower frequencies. Examples of the invention propose to change the resonant frequency of the package-PCB design by either cavity size/position of vias, or cavity thickness/ substrate thickness.

Examples of the invention are also described with reference to increasing a band stop resonance frequency of the packaged RF circuit and PCB substrate design, although in some examples it is envisaged that the band stop resonance frequency of the packaged RF circuit and PCB substrate design may be alternatively decreased, if this helps reduce the insertion loss at the desired operating frequency.

Examples of the invention are also described with reference to re-configuring a 9-pin BGA as a 7-pin BGA, by replacing two BGAs with two vias within a PCB substrate, and then re-locating these newly introduced vias within the PCB substrate to reduce the distance between the newly introduced vias to vias of the pre-existing design. In other examples, a different number-pin BGA package may benefit from the concepts herein described, as well as more or less BGAs being reconfigured as vias.

Examples of the invention are also described with reference to creating a cavity around a RF signal-carrying BGA. The cavity created in examples of the invention surrounds approximately 240 degrees of the RF signal-carrying BGA. However, in other examples, it is envisaged that the created cavity may surround anywhere between 180 degrees and 330 degrees of the RF signal-carrying BGA.

A first example packaged RF circuit and PCB substrate design is achieved by re-configuring the known BGA-via configuration, to convert one or more known BGAs to vias. In this manner, the frequency response of the packaged RF circuit and PCB design is modified. Furthermore, the re-configured BGA-via configuration, in the first example, includes a re-positioning of the newly introduced vias towards the RF signal-carrying BGA. This reduces the insertion loss when transferring the RF signal from the package to the substrate, via the RF signal-carrying BGA, due to shifting the resonance frequency. In examples of the invention, a reduction in insertion loss of approximately 2dB may be achieved with the proposed re-configured architecture.

Thus, in a first aspect of the invention, a packaged RF circuit is described that includes: a PCB substrate comprising at least one electrically conductive transmission line on a top portion of the PCB substrate, wherein the PCB substrate comprises a plurality of vias passing there through coupling the top portion of the PCB substrate to a ground plane; and an integrated circuit package located atop the PCB substrate in a vertical plane and electrically coupled to the PCB substrate via a plurality of ball grid arrays, BGAs. A first BGA is configured to carry at least one RF signal from the package to the PCB substrate. In the vertical plane, a first portion of the plurality of vias is offset from an adjacent first portion of the plurality of BGAs by a first distance, and a second portion of the plurality of vias located around a substantial portion of the first BGA is offset from a respective adjacent second portion of the plurality of BGAs by a second distance that is less than the first distance.

In this manner, by locating vias closer to the first BGA that carries the at least one RF signal, a frequency response of the packaged RF circuit (that is dependent upon the combination of BGAs and vias in a vertical plane around the first BGA) may be affected. In one example, the frequency response of the packaged RF circuit is affected by re-configuring a resonance frequency of the packaged RF circuit, for example by shifting it compared to known packaged RF circuits, thereby resulting in a flatter response over a wider frequency range. This re-configured resonance frequency may be configured such that a reduction in insertion loss of the package to PCB transition of the at least one RF signal may be achieved.

In some examples. the second portion of the plurality of vias and respective adjacent second portion of the plurality of BGAs being located around a substantial portion of the first BGA are configured to provide an electromagnetic field cavity around the first BGA. In one example, the electromagnetic field cavity around the first BGA that provides a particular resonant frequency. In one example, the shifted resonant frequency imparts a low insertion loss at the frequency of the at least one RF signal being transferred from the package to the PCB substrate via the first BGA.

In some examples, the first distance may be in a range of 0.12mm to 0.13mm and the second distance may be in the range of 0.105mm to 0.115mm. In some examples, when compared to known packaged RF circuits, at least one via of the second portion of the plurality of vias has replaced at least one BGA from a regular BGA formation. In some examples, two vias are used to replace two similarly located BGAs (in an electromagnetic field sense) and positioned closer to the first BGA to reduce an electromagnetic field cavity around the first BGA.

In some examples, the PCB substrate may be a multi-layer PCB substrate whereby a depth/height of at least one layer of the multi-layer PCB substrate is also configured to reduce an insertion loss of a package-transferred at least one RF signal. In this regard, the depth/height of at least one layer of the multi-layer PCB substrate may be configured to further provide a particular resonant frequency. In some examples, the multi-layer PCB substrate may include a proximity-coupled transmission line antenna in order to radiate the package-transferred at least one RF signal from a radio frequency unit, such as a radar unit operational in a 77-79GHz frequency range.

In a second aspect of the invention, a RF unit, such as a radar unit operational in a 77-79GHz frequency range, comprises a packaged RF circuit according to the first aspect of the invention.

In a third aspect of the invention, a PCB substrate is described that includes at least one electrically conductive transmission line on a top portion of the PCB substrate, wherein the PCB substrate includes a plurality of vias passing there through, coupling the top portion of the PCB substrate to a ground plane. The PCB substrate is configured according to the packaged RF circuit of the first aspect of the invention.

In a fourth aspect of the invention, an integrated circuit package for locating atop a PCB substrate in a vertical plane and electrically couplable to the PCB substrate via a plurality of ball grid arrays, BGAs is described. A first BGA is configured to carry at least one RF signal from the integrated circuit package to the PCB substrate. The integrated circuit package configured according to the packaged RF circuit of the first aspect of the invention.

In a fifth aspect of the invention, a packaged RF circuit is described that comprises: a multi-layer printed circuit board, PCB, substrate comprising at least one electrically conductive transmission line on a top portion of the multi-layer PCB substrate, wherein the multi-layer PCB substrate comprises a plurality of vias passing there through coupling the top portion of the multi-layer PCB substrate to a ground plane. An integrated circuit package is located atop the PCB substrate in a vertical plane and electrically coupled to the PCB substrate via a plurality of ball grid arrays, BGAs, wherein a first BGA is configured to carry at least one RF signal from the package to the PCB substrate. A width of at least one layer of the multi-layer PCB substrate is configured to provide a lower insertion loss of a package-transferred at least one RF signal than with a standard thickness of a single layer substrate, but where one layer of the multi-layer substrate is therefore less than the standard thickness of a single layer substrate. In this manner, with a use of a multi-layer substrate with electrical connectivity in a region in the vicinity of the first BGA, a use of a smaller depth substrate to carry the at least one RF signal shifts a resonance frequency of the packaged RF circuit, and is thus able to reduce the insertion loss when transferring the RF signal from the package to the substrate via the RF signal-carrying BGA.

Thus, configuring a packaged RF circuit using either or both of the above examples results in a flatter frequency response over a wider frequency range, thereby reducing the insertion loss of the package to PCB transition.

Because the illustrated embodiments of the present invention may, for the most part, be implemented using electronic components and circuits known to those skilled in the art, details will not be explained in any greater extent than that considered necessary as illustrated below, for the understanding and appreciation of the underlying concepts of the present invention and in order not to obfuscate or distract from the teachings of the present invention.

Referring now to FIG. 5, a top view 500 of a first example of a packaged RF circuit and PCB substrate design with a re-assignment of a selected number of BGAs as Vias, together with a re-location of their position on the packaged RF circuit and PCB substrate, is illustrated, according to example embodiments of the invention. The first example of a package and PCB design includes a number of BGAs 530 and vias 520 for 77GHz radar applications. In particular, the first example of a packaged RF circuit and PCB substrate design also includes an RF signal BGA 510 that transfers an input RF signal to a PCB that includes a substrate. The top view 500 shows a number of vias 520 that pass through the RF substrate and a number of BGA connections 530 that electrically connect the packaged RF circuit to the PCB substrate.

In accordance with example embodiments, one or more BGAs has/have been re-configured from the known package and PCB design as vias. In particular, one or more previously configured BGAs has/have been replaced with vias 524, 526 in FIG. 5, and these new vias have been located closer to the RF signal BGA 510 than was the case in FIG. 2 with the original BGAs. In one example, the distance between the previous adjacent BGAs and vias has been changed/reduced from 0.125mm to a distance of 0.11 mm between the new vias and the same original vias, In this manner, the resonant frequency of the package-PCB design is changed by adapting (and reducing, in this example) the cavity size.

As illustrated in FIG. 5, the cavity created in examples of the invention surrounds approximately 240 degrees of the RF signal-carrying BGA. However, in other (non-illustrated) examples, it is envisaged that the created cavity may surround anywhere between 180 degrees and 330 degrees of the RF signal-carrying BGA.

Although in this example a reduction in a distance of approximately 10% between vias has been effected to reduce the cavity size, it is envisaged that a greater or lesser percentage difference between the new vias and the same original vias may be employed in other examples to further adapt the resonant frequency of the package-PCB design, dependent upon the band-stop frequency response desired.

In some examples, it is envisaged that the PCB substrate for 77-79GHz Radar may be manufactured using known substrates, such as RO3003 from Rogers Isola Astra MT™ and Taconic™ DS3, each of which has a typical dielectric constant of Dk=3.0, and a substrate minimum thickness of 5mil (0.127µm).

Referring now to FIG. 6, an example packaged RF circuit and PCB substrate design 600 showing an electro-magnetic field of the package and PCB of FIG. 5, is illustrated according to example embodiments of the invention. The example packaged RF circuit and PCB substrate design 600 is a top view of the first example of a packaged RF circuit and PCB substrate design with a re-assignment of a selected number of BGAs as Vias, together with a re-location of their position on the package and RF substrate. The first example of a packaged RF circuit and PCB substrate design includes a number of BGAs 530 and vias 520 for 77-79GHz radar applications. In particular, the first example of a packaged RF circuit and PCB substrate design also includes an RF signal BGA 510 that transfers an input RF signal to a PCB that includes a substrate. The top view shows a number of vias 520 that pass through the PCB substrate and a number of BGA connections 530 that electrically connect the package to the PCB. In particular, in this example, previously configured BGAs have been replaced with vias 524, 526, as in FIG. 5. Furthermore, these new vias 524, 526 have been located closer to the RF signal BGA 510 than was the case in FIG. 2 with the original BGAs, In this manner, the resonant frequency of the package-PCB design is changed by adapting (and reducing, in this example) the cavity size 610 and thereby increasing the resonant frequency exhibited by the cavity.

The inventors of the present invention identified that the resonant cavity primarily emanates from the cavity built by Vias in the PCB substrate. The inventors of the present invention also identified that several parameters may affect the resonance frequency of the cavity, for example: the number of Vias and their position; the thickness of the RF substrate; etc.

Therefore, referring now to FIG. 7, an example frequency response simulation 700 shows an improvement in insertion loss and operating frequency bandwidth using the example packaged RF circuit of FIG. 5, according to example embodiments of the invention. The frequency response simulation 700 shows a frequency response 730 of frequency 720 versus insertion loss 710 for the packaged RF circuit of FIG. 5. The frequency response simulation 700 shows that the resonant cavity now exhibits a much higher band stop frequency behaviour than the simulation 400 of FIG. 4 of the known packaged RF circuit. Thus, the band stop frequency response has been increased to significantly over 100GHz.

FIG. 8 illustrates a second example of a packaged RF circuit 800 using a multi-layer substrate 860 within a standard PCB substrate thickness, adapted according to a second example embodiment of the invention. The packaged RF circuit 800 includes: a multi-layer printed circuit board, PCB, substrate comprising at least one electrically conductive transmission line on a top portion of the multi-layer PCB substrate, wherein the multi-layer PCB substrate comprises a plurality of vias 720 passing there through coupling the top portion of the multi-layer PCB substrate to a ground plane; and an integrated circuit package located atop the PCB substrate in a vertical plane and electrically coupled to the PCB substrate via a plurality of ball grid arrays, BGAs 730. A first BGA is configured to carry at least one RF signal 510 from the package to the PCB substrate. A width of at least one layer of the multi-layer PCB substrate is configured to reduce an insertion loss of a package-transferred at least one RF signal 510.

Alternatively, in some examples, the packaged RF circuit 500 of FIG. 5 may be configured to be electrically connected to the multi-layer PCB substrate to further reduce an insertion loss of a package-transferred at least one RF signal 510.

Thus, in this example, the multi-layer PCB substrate 860 includes at least one electrically conductive transmission line on a top portion of the multi-layer PCB substrate, wherein the multi-layer PCB substrate includes a plurality of vias 820 passing there through coupling the top portion of the multi-layer PCB substrate 860 to a ground plane. An integrated circuit package 810 is located atop the PCB substrate 860 in a vertical plane and electrically coupled to the PCB substrate 860 via a plurality of ball grid arrays, BGAs 830. A first BGA is configured to carry at least one RF signal from the package to the PCB substrate 860. A width of at least one layer of the multi-layer PCB substrate, but less than the total width of the whole PCB substrate, is configured to reduce an insertion loss of a package-transferred at least one RF signal.

In this example, the PCB substrate operating at RF frequencies has been replaced by a multi-layer substrate 860. In particular, the total thickness of the multi-layer PCB (RF) substrate, is maintained at the same thickness 840 as a known PCB standard, i.e. 127µm, so that it can be used at that particular operating frequency. However, in accordance with example embodiments, a thin layer (with optimized layer thickness) located under the package area is configured such that the width of the thin layer of the multi-layer structure affects the frequency response of the packaged RF circuit using a multi-layer substrate, and therefore the insertion loss of the package to substrate transitions of the RF signal.

In some examples, as illustrated, the packaged RF circuit 810 using a multi-layer substrate 860 within a standard thickness concept advantageously makes it feasible for antenna designs, such as a proximity-coupled transmission line antenna 850 to be included within the multi-layer substrate in the RF front-end and adjacent the packaged integrated circuit. It is envisaged that in other examples, alternative transmission line-based antenna or circuit component designs may be included within the multi-layer structure

In the foregoing specification, the invention has been described with reference to specific examples of embodiments of the invention. It will, however, be evident that various modifications and changes may be made therein without departing from the scope of the invention as set forth in the appended claims and that the claims are not limited to the specific examples described above. The connections as discussed herein may be any type of connection suitable to transfer signals from or to the respective nodes, units or devices or packages or transmission lines, for example via intermediate elements such as BGAs. Accordingly, unless implied or stated otherwise, the connections may for example be direct connections or indirect connections. Also, plurality of connections may be replaced with a single connection that transfers multiple signals serially or in a time multiplexed manner. Likewise, single connections carrying multiple signals may be separated out into various different connections carrying subsets of these signals. Therefore, many options exist for transferring signals.

Those skilled in the art will recognize that the architectures depicted herein are merely exemplary, and that in fact many other architectures can be implemented which achieve the same functionality. Any arrangement of components to achieve the same functionality is effectively 'associated' such that the desired functionality is achieved. Hence, any two components herein combined to achieve a particular functionality can be seen as 'associated with' each other such that the desired functionality is achieved, irrespective of architectures or intermediary components. Likewise, any two components so associated can also be viewed as being 'operably connected,' or 'operably coupled,' to each other to achieve the desired functionality.

Furthermore, those skilled in the art will recognize that boundaries between the above described operations merely illustrative. The multiple operations may be combined into a single operation, a single operation may be distributed in additional operations and operations may be executed at least partially overlapping in time. Moreover, alternative embodiments may include multiple instances of a particular operation, and the order of operations may be altered in various other embodiments.

Also for example, in one embodiment, the illustrated examples may be implemented as circuitry located on a single integrated circuit or within a same device. Alternatively, the circuit and/or component examples may be implemented as any number of separate integrated circuits or separate devices interconnected with each other in a suitable manner. The specifications and drawings are, accordingly, to be regarded in an illustrative rather than in a restrictive sense.

In the claims, any reference signs placed between parentheses shall not be construed as limiting the claim. The word 'comprising' does not exclude the presence of other elements or steps then those listed in a claim. Furthermore, the terms 'a' or 'an,' as used herein, are defined as one, or more than one. Also, the use of introductory phrases such as 'at least one' and 'one or more' in the claims should not be construed to imply that the introduction of another claim element by the indefinite articles 'a' or 'an' limits any particular claim containing such introduced claim element to inventions containing only one such element, even when the same claim includes the introductory phrases 'one or more' or 'at least one' and indefinite articles such as 'a' or 'an.' The same holds true for the use of definite articles. Unless stated otherwise, terms such as 'first' and 'second' are used to arbitrarily distinguish between the elements such terms describe. Thus, these terms are not necessarily intended to indicate temporal or other prioritization of such elements. The mere fact that certain measures are recited in mutually different claims does not indicate that a combination of these measures cannot be used to advantage.

## Claims

1. A packaged radio frequency, RF, circuit (500) comprises:
a printed circuit board, PCB, substrate comprising at least one electrically conductive transmission line on a top portion of the PCB substrate, wherein the PCB substrate comprises a plurality of vias (520) passing there through coupling the top portion of the PCB substrate to a ground plane;
an integrated circuit package located atop the PCB substrate in a vertical plane and electrically coupled to the PCB substrate via a plurality of ball grid arrays, BGAs (530), wherein a first BGA is configured to carry at least one RF signal (510) from the package to the PCB substrate;
wherein, in the vertical plane, a first portion of the plurality of vias (520) are offset from an adjacent first portion of the plurality of BGAs (530) by a first distance, and a second portion of the plurality of vias (520) located around a substantial portion of the first BGA are offset from a respective adjacent second portion of the plurality of BGAs (530) by a second distance that is less than the first distance.

2. The packaged RF circuit (500) of Claim 1 wherein the second portion of the plurality of vias (520) and respective adjacent second portion of the plurality of BGAs (530) being located around a substantial portion of the first BGA are configured to provide an electromagnetic field cavity around the first BGA.

3. The packaged RF circuit (500) of Claim 2 wherein the second portion of the plurality of vias (520) and respective adjacent second portion of the plurality of BGAs (530) being located around a substantial portion of the first BGA are configured to provide an electromagnetic field cavity around the first BGA that provides a particular resonant frequency.

4. The packaged RF circuit (500) of Claim 3 wherein the second portion of the plurality of vias (520) and respective adjacent second portion of the plurality of BGAs (530) being located around a substantial portion of the first BGA are configured to provide an electromagnetic field cavity around the first BGA that provides a resonant frequency that imparts a low insertion loss at the frequency of the at least one RF signal (510) being transferred from the package to the PCB substrate via the first BGA.

5. The packaged RF circuit (500) of any preceding Claim wherein the first distance is in the range of 0.12mm to 0.13mm and the second distance is in a range of 0.105mm to 0.115mm.

6. The packaged RF circuit (500) of any preceding Claim wherein at least one via of the second portion of the plurality of vias (520) has replaced at least one BGA (530) from a regular BGA formation.

7. The packaged RF circuit (500) of any preceding Claim wherein the PCB substrate is a multi-layer printed circuit board, PCB, substrate and a width of at least one layer of the multi-layer PCB substrate is configured to reduce an insertion loss of a package-transferred at least one RF signal (510).

8. The packaged RF circuit (500) of Claim 7 wherein the width of at least one layer of the multi-layer PCB substrate is configured to provide a particular resonant frequency thereby reducing an insertion loss of the package-transferred at least one RF signal (510).

9. The packaged RF circuit (500) of Claim 7 or Claim 8 wherein the multi-layer PCB substrate comprises a proximity-coupled transmission line antenna to radiate the package-transferred at least one RF signal (510).

10. The packaged RF circuit (500) of any preceding Claim wherein the packaged RF circuit (500) is one of a packaged RF front-end circuit or a packaged RF input-output circuit and the at least one RF signal is at a radar communication frequency.

11. The packaged RF circuit (500) of Claim 10 wherein the radar communication frequency is in a 77-79GHz range.

12. A radio frequency, RF, unit (300) comprises a packaged RF circuit (500) that includes:
a printed circuit board, PCB, substrate comprising at least one electrically conductive transmission line on a top portion of the PCB substrate, wherein the PCB substrate comprises a plurality of vias (520) passing there through coupling the top portion of the PCB substrate to a ground plane;
an integrated circuit package located atop the PCB substrate in a vertical plane and electrically coupled to the PCB substrate via a plurality of ball grid arrays, BGAs (530), wherein a first BGA is configured to carry at least one RF signal (510) from the package to the PCB substrate;
wherein, in the vertical plane, a first portion of the plurality of vias (520) are offset from an adjacent first portion of the plurality of BGAs (530) by a first distance, and a second portion of the plurality of vias (520) located around a substantial portion of the first BGA are offset from a respective adjacent second portion of the plurality of BGAs (530) by a second distance that is less than the first distance

13. A printed circuit board, PCB, substrate comprising at least one electrically conductive transmission line on a top portion of the PCB substrate, wherein the PCB substrate comprises a plurality of vias (520) passing there through coupling the top portion of the PCB substrate to a ground plane; and wherein the PCB substrate is configured according to the packaged RF circuit (500) of Claim 1.

14. An integrated circuit package for locating atop a printed circuit board, PCB, substrate in a vertical plane and electrically couplable to the PCB substrate via a plurality of ball grid arrays, BGAs (530), wherein a first BGA is configured to carry at least one RF signal (510) from the integrated circuit package to the PCB substrate; the integrated circuit package configured according to the packaged RF circuit (500) of Claim 1.

15. A packaged radio frequency, RF, circuit (800) comprises:
a multi-layer printed circuit board, PCB, substrate comprising at least one electrically conductive transmission line on a top portion of the multi-layer PCB substrate, wherein the multi-layer PCB substrate comprises a plurality of vias (820) passing there through coupling the top portion of the multi-layer PCB substrate to a ground plane;
an integrated circuit package located atop the PCB substrate in a vertical plane and electrically coupled to the PCB substrate via a plurality of ball grid arrays, BGAs (830), wherein a first BGA is configured to carry at least one RF signal (510) from the package to the PCB substrate; wherein a width of at least one layer of the multi-layer PCB substrate is configured to reduce an insertion loss of a package-transferred at least one RF signal (510).
